Europäisches Patentamt

European Patent Office

Office européen des brevets

(11) Publication number: **0 420 604 A1**

## (12) EUROPEAN PATENT APPLICATION

(21) Application number: 90310520.3

(22) Date of filing: 26.09.90

(51) Int. Cl.⁵: **H01R 4/04, H05K 1/14**

(30) Priority: 27.09.89 US 413413

(43) Date of publication of application:
**03.04.91 Bulletin 91/14**

(84) Designated Contracting States:
**AT BE CH DE DK ES FR GB GR IT LI LU NL SE**

(71) Applicant: MOTOROLA, INC.
**1303 East Algonquin Road**
**Schaumburg, IL 60196(US)**

(72) Inventor: Leicht, John Laurence
**12 Norbert Drive**
**Hawthorn Woods, Illinois 60047(US)**

(74) Representative: Dunlop, Hugh Christopher et
al
**Motorola European Intellectual Property**
**Operations Jays Close Viables Industrial**
**Estate**
**Basingstoke, Hampshire RG22 4PD(GB)**

(54) Selectively conductive adhesive device for simultaneous electrical and mechanical coupling.

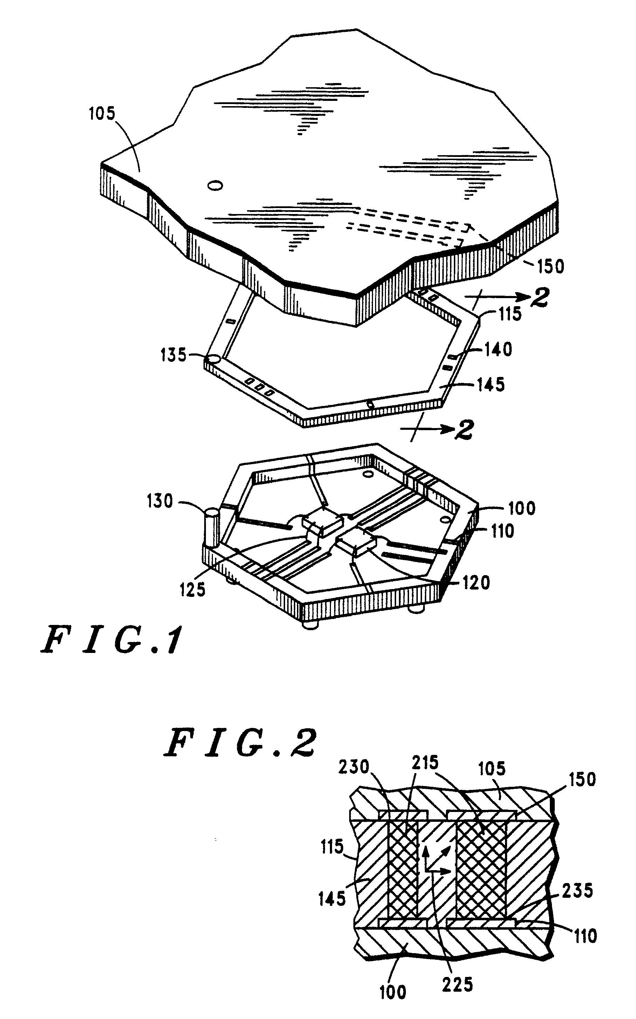

(57) An adhesive interconnection device of Figure 2 (115) providing a simplified simultaneous electrical and mechanical interconnection using one preformed member, comprised of a pattern of non-pressure activated electrically conductive adhesive members (140) and nonconductive adhesive members (145), which must be aligned with the conductive pads of at least two planar electrical devices (100 and 105). Sandwiching the device (115) between at least two electrical devices causes simultaneous electrical conduction paths and mechanical bonds (230) between the two electrical devices. An additional heat curing step may be introduced to achieve the proper conductivity level in the electrically conductive members required for a specific application.

FIG.1

# SELECTIVELY CONDUCTIVE ADHESIVE DEVICE FOR SIMULTANEOUS ELECTRICAL AND MECHANICAL COUPLING

## TECHNICAL FIELD

This invention relates generally to electrical and mechanical interconnection devices and more particularly to adhesive interconnect devices.

## BACKGROUND OF THE INVENTION

Various known methods of attaching electrical components to circuit boards or housings require several manufacturing process steps, depending upon attributes of the electrical component and the method of attachment used to interconnect the electrical component to the circuit board or housing. For instance, attributes such as size and shape of a component's package may require that glue be dispensed on the package or circuit board and then cured to hold the device in place during the soldering process to produce an acceptable electrical connection between the component and the circuit board.

Some devices having odd shapes or contours often use carriers to house the device in a manner that simplifies its interconnection to a circuit board. Although standard carriers aid in manufacturing a product, customized circuit carriers are needed in specific applications and therefore come in a multitude of shapes and sizes. This concept of carriers also applies to small circuits such as microwave processing circuits. This carrier may then be attached to the circuit board and its associated waveguides. The invention disclosed herein was originally designed to connect such an integral molded circuit carrier to an appropriate circuit board.

Alignment of the electrical leads or bonding pads of the molded circuit carrier to the circuit board is critical, particularly when spacing between bonding pads is on the order of several thousandth's of an inch. The carrier may be held in place by some mechanical means such as glue, epoxy, or fixtures, before an electrical interconnect process connects the electrical component leads of the carrier to the electrical pads on the circuit board. Typical electrical interconnect processes may include liquid soldering of carrier component leads to a circuit board or reflowing of solder paste for leaded surface mount carriers. There are numerous problems that result through resort to such processes, however.

One such problem, as well understood in the art, is ion migration between conductors enhanced by electrolytes associated with such processes. Other environmental induced electrolytes, such as water droplets, may also contribute to ion migration problems.

It is known in the art that interconnection devices can replace solder as the electrical interconnect and also provide an additional mechanical bonding compound to form a mechanical interconnection at the same location that the electrical interconnection is made. One such device is known as an anisotropic conductive adhesive. It may be in the form of an epoxy or film and is anisotropic because it only conducts in the Z-axis; isolation exists between all conduction points in the X and Y axes. The conductive particles within this material form the electrical interconnect and the adhesive qualities form the mechanical bond between a device and a circuit board.

However, this "Z-axis" material fails to accommodate at least one very important need. Generally, it is a pressure sensitive conductor, meaning pressure must be applied to this material before it is able to conduct. The conductive particles (metal powder) must be forced to come in intimate contact with the surfaces of the conductive points sought to be electrically connected. This provides electrical conduction in the Z-axis; the conductivity is typically a function of the pressure applied. Such a pressure activated conductor may allow variations in pressure, due to vibrations or other environmental changes after curing, and substantially affect electrical performance.

Another interconnection device exists in the form of an adhesive film. One such film has a conductive epoxy impregnated in a glass fabric to form a conductive film with moisture resistant adhesive qualities. The epoxy may be partially cured and later completely heat cured as part of a manufacturing process to interconnect an electronic device to a flexible circuit board or printed circuit board. Separate nonconductive adhesive films are also known in the art. These films are each available in die cut preforms. Two patents relating to the above materials are U.S. Patents 4,793,883 and 4,519,941.

Conductive adhesive films may also offer an advantage over solder processes in that flux residues are nonexistent without solder and also the epoxy curing temperature is significantly lower than the melting point of many solder compounds. Therefore, components on the carrier or circuit board are subject to lower temperatures during the manufacturing process. However, these films fail to allow one die cut preform to accommodate both selected conductive paths and selected nonconductive paths; they fail to provide a pattern of conductive locations capable of being integrated with selected nonconductive locations.

As circuit board area becomes more scarce, distances between interconnect pads or plated through holes become shorter to allow for maximum component density. Alignment of the interconnect device becomes more critical due to the tighter tolerance necessary to insure proper electrical connections. A method of alignment for a preformed interconnect device is much needed.

Accordingly, there exists a need for an improved interconnect device.

## BRIEF SUMMARY OF THE INVENTION

According to the present invention, there is provided a coupling device as claimed in claim 1. The disadvantages of prior art devices are overcome by the provision of a selectively conductive adhesive device for simultaneous electrical and mechanical coupling. An adhesive coupling device, having a predetermined shape, an electrically nonconductive member, and at least one electrically conductive member provide simultaneous electrical and mechanical coupling between at least two devices when sandwiched between them. Pressure need not be applied to the electrically conductive member to make it conductive. Any electrically conductive member provides both electrical and mechanical coupling.

The device has the advantages of being capable of being preformed and capable of electrical conduction in the absence of external mechanical bias (non-pressure activated). Furthermore it simultaneously makes an electrical connection and a mechanical bond between a molded circuit carrier's bond pads (or circuit traces) and a circuit board's circuit traces (or bond pads). The device can accommodate separate electrically conductive areas and electrically nonconductive areas thereby allowing a predetermined pattern of conductors to reside in the same preform as the nonconductive areas. The device can also significantly reduce the potential for ion migration between each of the separate electrically conductive locations and it can be readily alignable to insure proper placement.

In one embodiment, this adhesive coupling device simultaneously provides electrical and mechanical coupling between a molded circuit carrier and a circuit board. A predetermined pattern of non-pressure activated electrically conductive adhesive members, usually in the form of electrically conductive adhesive film, is incorporated with an electrically insulating adhesive member, such as a nonconductive adhesive film, having some predetermined shape which together comprise the device. The invention is aligned and sandwiched between these two objects, forming an electrical and mechanical coupling at the electrically conductive members and forming a mechanical bond at the electrically nonconductive members.

The device electrically and mechanically interconnects two objects in one step. The electrically conductive members do not require that pressure or heat be applied before they are able to conduct electrical energy. The electrically conductive members are electrically isolated from each other by the electrically nonconductive member between them. This substantially eliminates ion migration between the electrically conductive members.

## BRIEF DESCRIPTION OF THE DRAWINGS

FIG. 1 depicts a perspective assembly view of the simultaneous electrical and mechanical coupling between a molded circuit carrier and a circuit board in accordance with the invention.
FIG. 2 depicts an enlarged cross-sectional view of the selectively conductive adhesive preform between a molded circuit carrier and a circuit board in accordance with the invention.

## PREFERRED EMBODIMENT OF THE INVENTION

FIG. 1 depicts a microwave molded circuit carrier (100), that is interconnected to a circuit board (105) using a selectively conductive adhesive preform (115) as the coupling device between the molded circuit carrier and the circuit board. This type of product finds use in microwave frequency communication systems.

The molded circuit carrier (100) (comprised of metallized molded plastic) houses electrical components (120) that require electrical connection to the circuit board (105). This circuit carrier provides electromagnetic interference shielding and environmental protection for these components (120), including their wire bonds (125).

The preform (115) is selectively conductive because only specific areas within the adhesive preform are electrically conductive. These specific areas are the patterns of electrically conductive adhesive members that align between the molded circuit carrier and the circuit board to complete electrical connections.

Using only a one step manufacturing process, the patterned electrically conductive preform may be connected between two electrical devices. An alignment pin (130) is inserted (or molded) into the molded circuit carrier and used in conjunction with an alignment key on the preform (1 15), such as a hole (135), to align the electrically conductive members (140) of the adhesive preform (115) with their associated electrically conductive member on the circuit board (150). (Alignment between any two predetermined points may also serve as the alignment criteria and may incorporate the use of tabs, notches, or other suitable alignment keys for aligning the preform (115) between two objects.)

Once the preform (115) is sandwiched between the circuit carrier (100) and the circuit board (105), it provides both electrical and mechanical coupling at each electrically conductive member (140) and simultaneously provides mechanical coupling through its nonconductive member (145). Sandwiching may be accomplished by applying a nominal external force to the circuit carrier (100) and the circuit board (105) to form adequate coupling. The more parallel the surfaces, the more uniform the bond line thickness. However, this force is a nominal attachment force and is not needed to cause the electrically conductive adhesive to become conductive.

The electrically conductive adhesive members (140) within the preform (115) are capable of conducting electrical energy prior to any application of external pressure. However, the conductivity of the material used to form the electrically conductive members may be enhanced by curing this material once mechanical bonds (via the adhesive) and electrical bonds (adhesive forcing contact between two electrically conductive materials) couple the carrier (100) and circuit board (105) together.

FIG. 2. depicts this coupling via a cross-sectional view of the preform (115) coupled between a circuit board (105) and a molded circuit carrier (100). The preform (115) is comprised of electrically conductive members (215) with adhesive disposed on at least part of the surfaces that make intimate contact with the circuit board (105) and the circuit carrier (100), and an electrically nonconductive member (145) with adhesive also disposed on at least part of the surfaces that make intimate contact with the circuit board (105) and the circuit carrier (100). Further, the electrically conductive members (215) of the preform provide an electrical interconnect between a circuit trace (or pad) (150) on the printed circuit board and a circuit trace (or pad) (110) on the circuit carrier. An alternative embodiment would include adhesive disposed throughout the preform.

The electrically conductive members (215) may be in the form of an electrically conductive adhesive film. This film may be comprised of conductive epoxy, conductive silicone adhesive, or any conductive material. The conductive material within the film may further be comprised of silver, silver palladium, copper palladium, silver plated copper, or any other electrically conductive material suitable for the specific application.

Electrically conductive adhesive members (215) are electrically isolated from one another by the dielectric properties associated with the nonconductive adhesive member (145). These properties substantially inhibit formation of bridges of moisture between electrically conductive members, thereby substantially limiting ion migration (should the conductive material be prone to migration) between the electrically conductive members; the dielectric may encompass each member (225) in all surface planes except the portions of the electrically conductive members (215) which contact the circuit board and the molded circuit carrier. The electrically nonconductive member (145) may be in the form of a nonconductive adhesive film. The electrically conductive members have adhesive qualities in addition to electrical qualities, therefore mechanical and electrical coupling (230) is present at each electrically conductive member. Only mechanical coupling occurs at the nonconductive members (235) (via the adhesive).

When the mechanical coupling causes the surfaces of the preform (115) to come in intimate contact with the surfaces of the molded circuit carrier and the circuit board, an environmental seal, meaning substantial protection against moisture and substances which contribute to the formation of ion migration electrolytes, may be formed around the pads on the molded circuit carrier and the circuit board. The non-conductive adhesive members adhere to the surfaces surrounding the contact pads on the circuit carrier and the circuit board thereby covering locations between contact points on the surfaces of the two electrical devices where moisture may penetrate. The use of a moisture resistant conductive and non-conductive adhesive films would enhance this feature.

The device is capable of being formed into a predetermined shape and it is capable of substantially maintaining that shape. Electrically conductive adhesive films and electrically non-conductive adhesive films are available and may be used in fabrication of the invention. Other electrically conductive and non-conductive materials capable of being preformed may also suffice.

Although this invention applies to interconnect a molded circuit carrier to a circuit board, other embodiments may suit electrical interconnection applications between at least two electrical devices provided the materials used in making the electrically selective adhesive preform conform with considerations such as coefficients of thermal expansion requirements, conductivity requirements, environmental requirements, and mechanical requirements of the specific application. An example of another such embodiment is the interconnection of electrical components to flexible circuitry.

## Claims

1. A coupling device used between at least two objects requiring both mechanical coupling and electrical coupling, comprised of:
(a) an electrically insulating member having;
(i) a predetermined shape; and
(ii) adhesive disposed thereon; and
(b) at least one, non-pressure activated, electrically conductive member disposed through the insulating member with the non-pressure activated electrically conductive member having adhesive disposed thereon;
such that disposing the coupling device between the two objects simultaneously provides electrical coupling between the two objects and mechanical coupling between the two objects wherein electrical and mechanical coupling is provided by the non-pressure activated electrically conductive member and mechanical coupling is provided by the electrically insulating member.

2. The device of Claim 1 wherein the non-pressure activated electrically conductive member is comprised of a conductive adhesive epoxy.

3. The device in accordance with Claim 2 wherein the conductive adhesive epoxy is thermally cured.

4. The device of any one of the preceding claims wherein the non-pressure activated electrically conductive member is comprised of silver.

5. The device of any one of claims 1 to 3 wherein the non-pressure activated electrically conductive member is comprised of silver palladium or copper palladium.

6. The device of any one of the preceding claims wherein the non-pressure activated electrically conductive member is capable of electrical conduction in the absence of mechanical bias.

7. The device of any one of the preceding claims wherein the electrically insulating member is comprised of a non-conductive adhesive epoxy.

8. The device of any one of the preceding claims wherein the coupling device and the two objects encapsulate at least one point of electrical coupling between the two objects such that an environmental seal is formed, thereby substantially limiting ion migration from the point of electrical coupling to another electrically conductive point.

9. The device of any one of the preceding claims wherein a non-pressure activated electrically conductive member is isolated from an adjacent non-pressure activated electrically conductive member by the electrically insulating member such that ion migration is substantially limited between each non-pressure activated electrically conductive member.

10. A coupling device according to any one of the preceding claims, further comprising means for aligning the coupling device to at least one of the objects

11. The device of Claim 10 wherein the means for aligning the coupling device is comprised of an alignment key in the electrically insulating member.

105

150

2

115

135

140

145

2

130

100

110

125

120

*FIG.1*

*FIG.2*

230  215  105  150

115

145

235

110

100  225

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 223 464 (MINNESOTA MINING & MANUFACTURING)<br>* Abstract; figures 3,5; "Summary of the invention" * | 1,6,8,9 | H 01 R 4/04<br>H 05 K 1/14 |
| Y | | 10,11 | |
| Y | US-A-4 225 900 (RAYTHEON)<br>* Figure 3 * | 10,11 | |
| A | DE-A-3 240 407 (VDO) | | |
| P,X | GB-A-2 222 327 (SHIN-ETSU)<br>* Abstract; figure 7; page 13, lines 1-20 * | 1-9 | |
| P,X | GB-A-2 215 661 (SHIN-ETSU)<br>* Abstract; page 9, line 2 - page 11, line 19; figure 3 * | 1,4-6,8,9 | |

|  |
|---|
| TECHNICAL FIELDS SEARCHED (Int. Cl.5) |
| H 01 R<br>H 05 K |

The present search report has been drawn up for all claims

| Place of search | Date of completion of search | Examiner |
|---|---|---|
| The Hague | 08 January 91 | PROHASKA G.A.F. |